# EUROPÄISCHE PATENTSCHRIFT

(11) **EP 0 552 494 B1**
(45) Veröffentlichungstag und Bekanntmachung des Hinweises auf die Patenterteilung: **26.03.1997**
(21) Anmeldenummer: 92122006.7
(22) Anmeldetag: 24.12.1992
(51) Int. Cl.: H04B 1/10

(54) **Verfahren und Schaltungsanordnung zur Offset-Korrektur in einem TDMA-Funkempfänger**
Method and circuit for offset correction in a TDMA radio receiver
Procédé et dispositif de circuit pour la correction offset dans un récepteur radio TDMA

(30) Priorität: 18.01.1992 DE 4201194
(43) Veröffentlichungstag der Anmeldung: 28.07.1993
(73) Patentinhaber: Alcatel SEL Aktiengesellschaft, D-70435 Stuttgart (DE)
(72) Erfinder: Neustadt, Alf, W-7000 Stuttgart 1 (DE)
(74) Vertreter: Pohl, Herbert, Dipl.-Ing

(56) Entgegenhaltungen:
- EP-A- 0 318 684
- US-A- 4 873 702
- US-A- 5 052 027
- WO91/05427

## Beschreibung

Die Erfindung betrifft ein Verfahren nach dem Oberbegriff des Anspruchs 1 und eine Schaltungsanordnung nach dem Oberbegriff des Anspruchs 7.

Die in gleichspannungsgekoppelten Verstärkerschaltungen auftretenden Nullpunktabweichungen (Offsetspannungen) werden auf unterschiedliche Art und Weise abgeglichen.

Eine herkömmliche Methode ist es, die jeweilige Verstärkerschaltung zu Beginn ihrer Inbetriebnahme mittels einer am Verstärkereingang angelegten Kompensationsspannung einmalig abzugleichen. Nachfolgende Änderungen der Nullpunktabweichung durch Temperaturdrift o.ä. werden dabei nicht berücksichtigt.

Darüberhinaus sind Methoden bekannt, die einen mehrmaligen Abgleich mittels eines Regelkreises ermöglichen.

Hierzu sei z.B. auf den in der Druckschrift "Behavior Research Methods, Instruments & Computers", 1990, 22(1) veröffentlichten Artikel "Automated offset compensation for DC biopotential measurements" von T.F. Collura et al. verwiesen.

Die Empfangssignale können abschnittsweise (zeitschlitzweise) unterschiedlich hohe Pegel führen. Dies ist insbesondere in TDMA-Funkempfängern der Fall, die wie im GSM-Standard eine Zeitschlitzzuordnung auf feste (Zeit-) Kanäle aufweisen, so daß entsprechend den unterschiedlichen Übertragungsverhältnissen in den einzelnen Kanälen (d.h. von den verschiedenen Sendern) von Zeitschlitz zu Zeitschlitz stark schwankende Pegel auftreten.

Offset-Korrektur-Verfahren von Eingangssignalen mit abschnittsweise wechselnden Pegeln, wie sie insbesondere in TDMA-Funkempfängern auftreten, werden u.a. in der Patentschrift US 4,873,702 und der Patentschrift WO91/05427 dargestellt.

In beiden Verfahren wird ein im jeweiligen Abschnitt definiertes Zeitintervall mit einem bekannten Mittelwert ("preamble signal" bzw. "DC compensation signal") zur Ermittlung des Korrekturwertes herangezogen. Dieser bleibt nach Prinzip obiger Verfahren von den Schwankungen der Eingangssignalpegel unbeeinflußt. Für Eingangssignale, die keine derartigen Zeitintervalle aufweisen, können obige Verfahren keine sinnvolle Offset-Korrektur leisten. Stehen jedoch derartige Zeitintervalle prinzipiell zur Verfügung, so stellt sich deren Auswertung zur Ermittlung eines geeigneten Korrekturwertes insbesondere dann problematisch dar, wenn das eintreffende Empfangssignal innerhalb jeweils einer Zeitschlitzdauer beachtlich verfälscht wird.

Dies ist u.a. bei Fading oder Mehrwegausbreitung der Fall, wie sie z.B. in nach GSM Standard spezifizierten Funksystemen auftreten. Durch diese Effekte sind auch die obengenannten Zeitintervalle ("preamble signal" bzw. "DC compensation signal") derart verfälscht, daß daraus ermittelte Korrekturwerte dem Betrag nach stark von dem tatsächlich zu kompensierenden Offsetwert abweichen können und somit zu einer Fehlkompensation führen können.

Der Erfindung liegt die Aufgabe zugrunde, ein Korrekturverfahren und eine danach arbeitende Schaltungsanordnung darzustellen, welche einen sich selbst einstellenden, nicht stark schwankenden (gleitenden) Korrekturwert erzielt, wobei eine Fehlkompensation vermieden wird.

Die Aufgabe wird erfindungsgemäß gelöst durch ein Verfahren nach der Lehre des Anspruchs 1 und eine Schaltungsanordnung nach der Lehre des Anspruchs 7.

Danach werden in einem Vergleicher anhand eines Grenzwertes die einzelnen Abschnitte selektiert, wobei nur Abschnitte mit niedrigen Pegeln für eine Ermittlung des Korrekturwertes herangezogen werden. In Abschnitten mit hohen Pegeln ist der Anteil des tatsächlichen Offsets am Gesamtgleichanteil des einzelnen Abschnittes (Mittelwert) geringer, als in Abschnitten mit niedrigen Pegeln. Der tatsächliche Offsetwert muß zur Bildung eines sinnvollen Korrekturwertes möglichst genau ermittelt werden.

Eine jeweilige Mittelwertbildung über die Abschnitte mit niedrigen Pegeln ergibt Mittelwerte, die (in Abhängigkeit von der Wahl des Grenzwertes) nicht zu stark vom tatsächlichen Offsetwert abweichen.

Zur Bildung des Korrekturwertes folgt eine Auswertung dieser Mittelwerte, d.h. die (gewichtete) Summation über eine große Anzahl einzelner Mittelwerte. Aufgrund der Tatsache, daß das ursprüngliche Empfangssignal nach GSM-Standard langfristig gleichanteilfrei ist, d.h. eine Langzeitmittelung über das nicht durch einen Offset verfälschte Empfangssignal zu einem gegen Null tendierenden Wert führt, liefert obige Auswertung einen Korrekturwert, der seinem Betrag nach nahezu dem tatsächlichen Offsetwert entspricht. Durch die Selektion bleibt der Korrekturwert von Zeitschlitzen mit hohen Pegeln unberührt, wodurch eine Fehlkompensation vermieden wird.

Die Ermittlung des Korrekturwertes durch Auswertung mehrerer Mittelwerte (selektierter Zeitschlitze) führt zu einem gleitenden, nicht stark schwankenden Korrekturwert.

Vorteilhafte Weiterbildungen der Erfindung sind den Unteransprüchen zu entnehmen.

Nach Anspruch 2 wird zur Ermittlung des Korrekturwertes eine Mittelwertbildung zu Hilfe genommen, welche "nur" über Teilintervalle der selektierten Zeitschlitze erfolgt. Somit wird eine zeitintensive Mittelwertbildung über ganze Zeitschlitze ausgespart und eine schnellere Korrektur ermöglicht. Darüberhinaus werden am Anfang und Ende eines jeden Zeitschlitzes vorgesehene redundante Bits, welche Laufzeitverschiebungen bei der Signalübertragung abpuffern sollen, nicht miterfaßt. Weiterhin können auch Zeitschlitze mit einer kürzeren Zeitdauer als die ursprüngliche (z.B. kurze Testzeitschlitze bei Aufbau einer Verbindung, access bursts) ausgewertet werden, ohne Parameter des Verfahrens ändern zu müssen. Die Zeitdauer eines Teilintervalles darf jedoch höchstens die Dauer eines dieser kurzen Zeitschlitze umfassen.

Das Verfahren nach Anspruch 3 stellt eine Weiterbildung der Ermittlung des Korrekturwertes aus mehreren selektierten Zeitschlitzen dar, indem durch Wahl der Wichtung reelle Verhältnisse vom Anteil des aktuellen Zeitschlitzes (gewichteter Mittelwert) und dem Anteil vorheriger Zeitschlitze (vorherige(r) Korrekturwert(e)) eingestellt werden können. Die Stärke der Schwankungen, die der Korrekturwert unterliegt, kann somit stufenlos eingestellt werden.

Nach Anspruch 4 ist der Grenzwert, mittels dessen die Zeitschlitze selektiert werden, keine unbedingt fixe Größe, sondern eine Größe, die sich, je nach Anforderung (Auswertung), mittels Eingangssignal bestimmt und so die Selektion der Zeitschlitze steuert. Somit kann beispielsweise der Zustand vermieden werden, daß bei einem Eingangssignal mit fortlaufend hohen Pegeln kein Zeitschlitz oder nur wenige Zeitschlitze selektiert werden. Die Korrektur kann außerdem über definierte Zeitschlitze im Eingangssignal (Steuerintervalle) beeinflußt werden.

Nach Anspruch 5 ist der Grenzwert über die Zeit veränderbar. Somit können temporäre Bedingungen (z.B. Start- und Einschaltbedingungen) bei der Ermittlung des Korrekturwertes berücksichtigt werden.

Durch eine anfängliche, temporäre Anhebung des Grenzwertes zum Inbetriebnahmebeginn des Funkempfängers wird auch dann ein Mittelwert gebildet, falls die anfänglich eintreffenden Abschnitte Pegel aufweisen, die größer als der Grenzwert sind. Somit verharrt der Korrekturwert nicht auf seinem Startniveau (z.B. auf Null).

Im Verfahren nach Anspruch 6 sind eine minimal geforderte und eine maximal erlaubte Korrektor des Eingangssignales bestimmt. Die Begrenzung legt eine höchstzulässige relative Beeinflußung des Eingangswertes durch den Korrekturwert fest.

Die Begrenzung könnte vorteilhaft aus dem durchschnittlich zu erwartenden Pegelhub des Eingangssignales bestimmt werden. So würde bei einer langen vorzeichengleichen Pegelfolge ein Aufsummieren des Korrekturwertes über das durchschnittliche Pegelniveau hinaus vermieden.

Im folgenden wird die Erfindung anhand eines Ausführungsbeispiels unter Zuhilfenahme der beiliegenden Zeichnungen weiter erläutert.
- Fig. 1: zeigt eine TDMA-Funkempfängerschaltung mit jeweils einer Offset-Korrektur-Schaltung im I-Zweig (In-Phase-Komponente I) und im Q-Zweig (Quadratur-Komponente Q);
- Fig. 2: zeigt eine Offset-Korrektur-Schaltung;

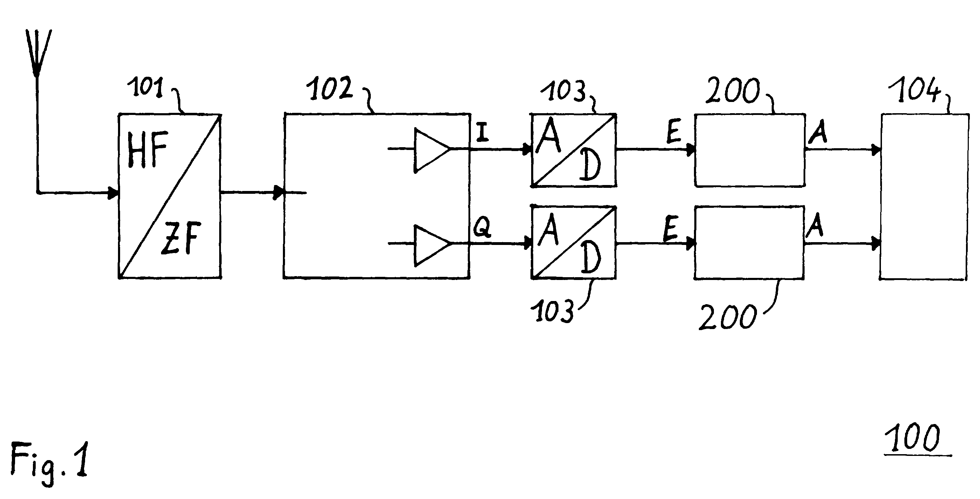

Die TDMA-Funkempfänger-Schaltung 100 nach Fig. 1 enthält eine Antenne, einen nachgeschalteten Mischer 101, einen an dessen Ausgang angeschlossenen Quadraturdemodulator 102 mit zwei ausgangsseitig angekoppelten Analog-Digital-Umsetzern 103, jeweils eine nachgeschaltete Offset-Korrektur-Schaltung 200 und eine Schaltung zur weiteren Digitalen Signalverarbeitung 104, die mit den Ausgängen der beiden Offset-Korrektur-Schaltungen verbunden ist.

Die Eingangssignale E (mit zeitschlitzweise wechselnden Pegeln) der Offset-Korrektur-Schaltungen sind durch Offset-Spannungen (Nullpunktabweichungen) in den Verstärkerstufen (z.B. im Quadraturdemodulator, A/D-Umsetzer) verfälscht und stehen nach Korrektur als Ausgangssignale A der Offset-Korrektur-Schaltung für die weitere Digitale Signalverarbeitung zur Verfügung.

Das im Ausführungsbeispiel behandelte Eingangssignal verfügt über eine Zeitschlitzdauer von 577 µs, was einer definierten Anzahl von 156,25 bit entspricht. Im Normalfall werden 142 feste bits (fixed bits) übertragen, wovon entsprechend der Wahl des Teilintervalles die mittleren 64 bit zur Ermittlung des Korrekturwertes herangezogen werden. Die Wahl des Teilintervalles zu einer Anzahl von 64 bit stellt eine Zweierpotenz dar und ermöglicht eine schnelle und einfache digitale Auswertung. Die Pegel des Eingangssignales umfassen ihrem Betrage nach einen Amplitudenbereich von etwa 10⁻³ - 10 V.

Die zu korrigierenden Offset-Spannungen können betragsmäßig etwa 10⁻¹ V erreichen und eine Drift von betragsmäßig etwa 10 mV/min aufweisen.

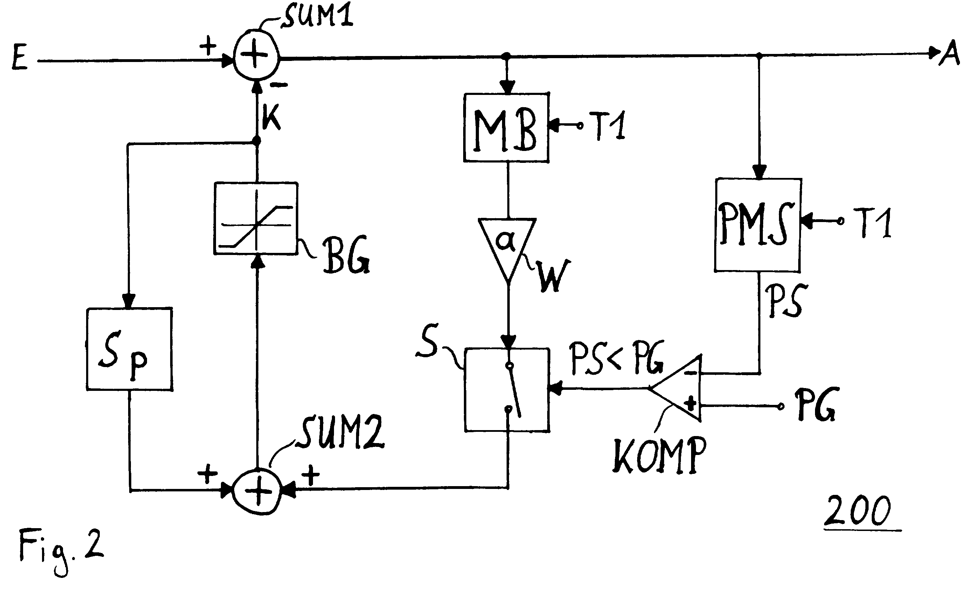

Fig. 2 zeigt die Offset-Korrektur-Schaltung 200 mit einer ersten Summationsstufe SUM1, einer zweiten Summationsstufe SUM2, einer Stufe zur Mittelwertbildung MB, einer Pegelmeßstufe PMS, einem Vergleicher KOMP, einer Wichtungsstufe W (mit einem Wichtungsfaktor 0<a<1), einem Speicher Sp, einer Schaltstufe S und einem Begrenzer BG.

Das Eingangssignal E wird auf die erste Summationsstufe SUM1 geführt und dort zeitschlitzweise mit einem Korrekturwert K derart verknüpft, daß sich am Ausgang der Summationsstufe SUM1 das Ausgangssignal A als Differenz A = E - K darstellt. Der Korrekturwert K wird wie folgt ermittelt:

Das Ausgangssignal A wird u.a. der Pegelmeßstufe PMS zugeführt, in welcher zeitschlitzweise der Amplitudenpegel oder eine daraus abgeleitete Größe (z.B. Leistungspegel) des Ausgangssignales A bestimmt wird. Die Pegelmeßstufe wird zu Beginn eines jeden Zeitschlitzes rückgesetzt und bleibt jeweils über eine Zeitdauer T1, welche kleiner als die Zeitschlitzdauer ist, aktiv. Die Ausgangsgröße PS der Pegelmeßstufe wird anschließend in dem Vergleicher KOMP mit einem Grenzwert PG verglichen. Der Grenzwert kann sowohl eine fixe Größe als auch eine veränderbare Größe darstellen (z.B. in der Art, daß der Grenzwert mit zunehmender Einschaltdauer reduziert wird). Im Ausführungsbeispiel liegt der Betrag des Grenzwertes im Bereich von etwa 10% - 50% des maximalen Empfangssignalpegels (PG = [0,1 ... o,5] PS max).

Der Vergleicher KOMP steuert die Schaltstufe S entsprechend obigem Vergleich wie folgt:
a) Ist die Ausgangsgröße PS über einen Zeitschlitz betrachtet kleiner als der Grenzwert PG (PS<PG), so wird die Schaltstufe S für diesen Zeitschlitz aktiv und der im Zeitschlitz über die Zeitdauer T1 bestimmte Mittelwert wird über die Wichtungsstufe W auf einen Eingang der zweiten Summationsstufe SUM2 geführt. Um einen sehr stabilen Korrekturwert zu erzielen, ist im Ausführungsbeispiel der Wichtungsfaktor a sehr klein gewählt mit etwa a = 0,01.
   Am Eingang der zweiten Summationsstufe SUM2 liegen der gewichtete Mittelwert und der im Speicher Sp abgelegte (alte) Korrekturwert an, welche zu einer Summe verknüpft werden und diese dem Eingang des Begrenzers BG zugeführt wird. Dieser kann den für den nächsten Zeitschlitz darzustellenden, neuen Korrekturwert K in seinem Amplitudenbereich, falls gefordert, einschränken.
   Im Fall "PS<PG" (niedriger Pegel) stellt sich demnach ein Korrekturwert K ein, der aus dem gespeicherten (alten) Korrekturwert und einem gewichteten Anteil des (aktuellen) Mittelwertes gebildet wird.
b) Ist die Ausgangsgröße PS über einen Zeitschlitz betrachtet größer als der Grenzwert PG (PS>PG) oder diesem gleich (PS=PG), so wird die Schaltstufe S für diesen Zeitschlitz inaktiv geschaltet. Die Ausgangsgröße des Speichers (alter Korrekturwert), welche direkt auf die zweite Summationsstufe SUM2 geführt ist, liegt dort als einzige Eingangsgröße an. Dadurch ergibt sich am Ausgang des Begrenzers BG ein Korrekturwert K, der dem alten Speicherwert (alter Korrekturwert) entspricht. Der Speicherwert ändert sich nicht und liegt als konstanter Korrekturwert K an der ersten Summationsstufe SUM1.

Es sind u.a. auch Ausführungsformen der Erfindung denkbar, die nicht mittels einer rekursiven Regelung arbeiten, sondern direkt vom Eingangssignal ausgehend einen Korrekturwert ermitteln, der durch (spätere) Addition zum Eingangssignal zu einem Abgleich führt (Vorwärtsregelung). Zur Realisierung verschiedener Ausführungsformen lassen sich vorteilhaft Digitale Signalprozessoren (DSP) einsetzen. Darüberhinaus sind analog arbeitende Ausführungsformen der Erfindung denkbar.

## Patentansprüche

1. Verfahren zur Korrektur einer Nullpunktabweichung in einer gleichspannungsgekoppelten Verstärkerschaltung (100) durch Ermitteln eines Korrekturwertes (K) unter Zuhilfenahme einer Mittelwertbildung (MB) und Addition des Korrekturwertes zu einem Eingangssignal (E),
**dadurch gekennzeichnet,** daß aus einem Eingangssignal mit abschnittsweise wechselnden Pegeln (PS) nur solohe Abschnitte zur Ermittlung des Korrekturwertes herangezogen werden, deren Pegel einen veränderbaren Grenzwert (PG) unterschreiten.

2. Verfahren nach Anspruch 1, mit einem Eingangssignal, das ein TDMA-Signal, bestehend aus Zeitrahmen mit n Zeitschlitzen, ist,
**dadurch gekennzeichnet,** daß die herangezogenen Abschnitte die Zeitschlitze sind und die Mittelwertbildung über Teilintervalle derselben erfolgt.

3. Verfahren nach Anspruch 1, dadurch gekennzeichnet, daß der Korrekturwert (K) fortlaufend mittels einer Addition des vorherigen Korrekturwertes oder mehrerer vorheriger Korrekturwerte und einem gewichteten, aus der Mittelwertbildung bestimmten Mittelwert ermittelt wird.

4. Verfahren nach Anspruch 1, dadurch gekennzeichnet, daß der Grenzwert (P6) sich aus einer Auswertung der Eingangssignalpegel oder daraus abgeleiteten Größen ergibt.

5. Verfahren nach Anspruch 1, dadurch gekennzeichnet, daß der Grenzwert (P6) bestimmten zeitlichen Veränderungen unterliegt.

6. Verfahren nach Anspruch 1, dadurch gekennzeichnet, daß der Korrekturwert (K) einer bestimmten Wertebereichsbegrenzung unterliegt.

7. Schaltungsanordnung zur Korrektur einer Nullpunktabweichung in einer gleichspannungsgekoppelten Verstärkerschaltung (100) durch Ermitteln eines Korrekturwertes (K) unter Zuhilfenahme einer Mittelwertbildung (MB) und Addition des Korrekturwertes zu einem Eingangssignal (E),
**dadurch gekennzeichnet,** daß die Schaltungsanordnung einen Vergleicher (KOMP) enthält, welcher aus einem Eingangssignal mit abschnittsweise wechselnden Pegeln (PS) nur solche Abschnitte zur Ermittlung des Korrekturwertes selektiert, deren Pegel einen veränderbaren Grenzwert (PG) unterschreiten.

## Claims

1. A method of correcting offset in a DC-coupled amplifier circuit (100) by adding a correction value (K) to an input signal (E), said correction value (K) being determined with the aid of an averaging operation (MB),
**characterized in** that of an input signal with levels (PS) changing from section to section, only those sections are used to determine the correction value whose levels are below a variable limit value (PG).

2. A method as claimed in claim 1 wherein the input signal is a TDMA signal, consisting of frames with n time slots,
**characterized in** that the sections used are the time slots, and that the averaging is performed over intervals of the same.

3. A method as claimed in claim 1, characterized in that the correction value (K) is determined continuously by adding the previous correction value or two or more previous correction values and a weighted value of the average determined by the averaging operation.

4. A method as claimed in claim 1, characterized in that the limit value (PG) is obtained by evaluating the input-signal levels or variables derived therefrom.

5. A method as claimed in claim 1, characterized in that the limit value (PG) is subject to particular variations with time.

6. A method as claimed in claim 1, characterized in that the correction value (K) lies within a particular range of values.

7. A circuit arrangement for correcting offset in a DC-coupled amplifier circuit (100) by adding a correction value (K) to an input signal (E), said correction value (K) being determined with the aid of an averaging operation (MB),
**characterized in** that the circuit includes a comparator (KOMP) which, to determine the correction value, selects from an input signal with levels (PS) changing from section to section only those sections whose levels are below a variable limit value (PG).

## Revendications

1. Procédé de correction d'un déplacement du zéro dans un montage amplificateur relié à une tension continue (100) par calcul d'une valeur de correction (K) à l'aide d'une détermination de valeur moyenne (MB) et de l'addition de la valeur de correction à un signal d'entrée (E), caractérisé par le fait que, dans un signal d'entrée à niveaux variables selon le secteur (PS), seuls les secteurs dont les niveaux sont inférieurs à une valeur limite (PG) variable sont utilisés pour calculer la valeur de correction.

2. Procédé correspondant à la revendication 1, avec un signal d'entrée qui est un signal AMRT composé d'un cadre temporel de n créneaux temporels, caractérisé par le fait que les secteurs utilisés sont les créneaux temporels et que la valeur moyenne est déterminée sur la base d'intervalles partiels de ceux-ci.

3. Procédé correspondant à la revendication 1, caractérisé par le fait que la valeur de correction (K) est calculée en continu au moyen d'une addition de la valeur de correction précédente ou de plusieurs valeurs de correction précédentes et d'une valeur moyenne pondérée déterminée à partir de la définition de la valeur moyenne.

4. Procédé correspondant à la revendication 1, caractérisé par le fait que la valeur limite (PG) est obtenue à partir du niveau du signal d'entrée ou de grandeurs qui en dérivent.

5. Procédé correspondant à la revendication 1, caractérisé par le fait que la valeur limite (PG) est soumise à certaines modifications temporelles.

6. Procédé correspondant à la revendication 1, caractérisé par le fait que la valeur de correction (K) est soumise à une limitation déterminée de la fourchette de valeur.

7. Configuration de circuit pour la correction d'un déplacement du zéro dans un montage amplificateur relié à une tension continue (100), par calcul d'une valeur de correction (K) effectué à l'aide de la détermination d'une valeur moyenne (MB) et de l'addition de la valeur de correction à un signal d'entrée (E),
caractérisée par le fait que la configuration de circuit comprend un comparateur (KOMP) qui, à partir d'un signal d'entrée à niveaux variables selon le secteur (PS), ne sélectionne pour calculer la valeur de correction que les secteurs dont les niveaux sont inférieurs à une valeur limite (PG) modifiable.
